# EUROPEAN PATENT APPLICATION

(11) **EP 4 491 590 A1**
(43) Date of publication of application: **15.01.2025**
(21) Application number: 23766927.0
(22) Date of filing: 09.03.2023
(51) Int. Cl.: C03B 20/00, C03C 3/06, C03C 17/02, C23C 4/129, F23D 14/22

(54) **METHOD FOR MANUFACTURING QUARTZ MEMBER, AND SILICA POWDER THERMAL SPRAY COATING METHOD**

(30) Priority: 11.03.2022 JP 2022038271
(71) Applicant: Mitsubishi Chemical Corporation, Tokyo 100-8251 (JP)
(72) Inventor: MUNEHIRA, Masami, Tokyo 100-8251 (JP)
(74) Representative: Vossius & Partner Patentanwälte Rechtsanwälte mbB
(86) International application number: PCT/JP2023/009067
(87) International publication number: WO 2023/171751

(57) **Abstract**

A method for manufacturing a quartz member including a step of spraying silica powder onto a target member surface while pushing it out with gas through a burner, the step being performed in an oxyhydrogen flame atmosphere, and a temperature of the target member surface being 1401°C to 2000°C. A method for spray coating silica powder including steps of: pushing the silica powder out with a carrier gas through a quartz burner having a triple or more multi-layer structure; and spraying the silica powder onto a target member surface while melting the silica powder under an oxyhydrogen flame atmosphere.

## Description

### Technical Field

The present invention relates to a manufacturing method of a quartz member, and a method for forming a quartz glass coating on a target member.

### Background Art

Quartz members obtained by spray coating quartz glass are used as machines, devices, containers, or the like used in semiconductor manufacturing processes.

As a method for coating quartz glass on a surface of a substrate, Patent Literature 1 describes a method of depositing a coating on a quartz member using a quartz oxyhydrogen burner.

However, in the method of Patent Literature 1, silica powder is mixed with oxygen gas by the so-called Bernoulli method, and since the powder is made to fall and accumulate on the substrate by using gravity, the coating target portion is limited to the upward surface of the substrate.

Patent Literature 2 describes a method for forming a quartz glass sprayed film on a side surface of a substrate using a plasma spray method.

However, in this plasma spraying method, since heated and melted particles are sprayed onto the substrate at high speed, the particles become flat and solidify after impact. For this reason, it is not suitable for obtaining a dense coating film without bubbles.

### Citation List

### Patent Literature

Patent Literature 1: JP H7-126025 A
Patent Literature 2: JP 2004-142996 A

### Summary of Invention

### Problem to be solved by the Invention

An object of the present invention is to provide a method for manufacturing a quartz member having a dense coating film without bubbles, a method for spray coating silica powder that can perform quartz coating at an arbitrary processing angle on a substrate having an arbitrary shape, and further a burner for the method.

### Solution to Problem

The inventors conducted extensive research to solve the above problem based on an understanding of the physicochemical phenomenology that acts on raw material particles up to the melting and film-forming stage, and discovered that the above problem can be solved by forming a coating using an oxyhydrogen burner made of quartz, and supplying silica powder as a raw material with a carrier gas at an arbitrary feed rate, thus arriving at the present invention. That is, the present invention is as follows.
[1] A method for manufacturing a quartz member, comprising a step of spraying a carrier gas containing silica powder onto a surface of a target member through a burner,
   wherein the step is performed in an oxyhydrogen flame atmosphere, and the temperature of the target member surface is 1401°C or higher and 2000°C or lower.
[2] The method for manufacturing a quartz member according to [1], wherein the burner has a multi-layer structure.
[3] The method for manufacturing a quartz member according to [2], wherein the multi-layer structure is a triple or more multi-layer structure.
[4] The method for manufacturing a quartz member according to [1], wherein the burner has supply tubes for silica powder, oxygen gas, and hydrogen gas.
[5] The method for manufacturing a quartz member according to [4], wherein the supply tubes of the burner are arranged such that the supply tube for silica powder, the supply tube for oxygen gas, and the supply tube for hydrogen gas are positioned in this order in the radial direction from the center of the burner.
[6] The method for manufacturing a quartz member according to [4], wherein the burner has a convergence point for the blowing flows of silica powder, oxygen gas, and hydrogen gas in front of the burner.
[7] The method for manufacturing a quartz member according to [1], wherein the burner has a tapered section tapered from the body to the tip of the burner, and the burner is provided with oxygen gas nozzles arranged in the tapered section on a concentric circle.
[8] The method for manufacturing a quartz member according to [7], wherein a plurality of oxygen gas nozzles are arranged on a concentric circle in the tapered section.
[9] The method for manufacturing a quartz member according to [8], wherein the burner is structured so that part of hydrogen gas flows into gaps between the oxygen gas nozzles.
[10] The method for manufacturing a quartz member according to [1], wherein the burner is a quartz burner.
[11] The method for manufacturing a quartz member according to [1], wherein the supply amount of silica powder is set to a set value selected from the range of 0.1 to 6 g/min per burner, and the amount of variation from the set value is ±3% or less with respect to the set value.
[12] The method for manufacturing a quartz member according to [1], wherein an amount of metal impurities in the silica powder is 0.1 ppm or less.
[13] The method for manufacturing a quartz member according to [1], further comprising a step of supplying the silica powder stored in a hopper to the burner through a suction line made of a tube, and a step of smoothing the surface of the silica powder in the hopper with a smoothing member.
[14] The method for manufacturing a quartz member according to [1], wherein the quartz member is a quartz jig.
[15] A method for spray coating a silica powder, comprising spraying a carrier gas containing silica powder onto a surface of a target member under an oxyhydrogen flame atmosphere through a burner having a multi-layer structure, wherein the burner is a quartz burner with a multi-layer structure of three or more layers; and, the silica powder is sprayed with the carrier gas while being melted under the oxyhydrogen flame atmosphere onto the surface of the target member to from a coating.
[16] The method for spray coating a silica powder according to [15], wherein the multi-layer structure is a multi-layer structure of three or more layers.
[17] The method for spray coating a silica powder according to [15] or [16],
   wherein the burner has a body including therein a silica powder supply tube, an oxygen gas supply tube, and a hydrogen gas supply tube in the radial direction from the center,
   the burner has a tapered section from the body to the tip of the burner,
   the tapered section is provided with a plurality of oxygen gas nozzles arranged in multiple concentric circles,
   the burner has a structure in which part of the hydrogen gas flows into gaps between the oxygen gas nozzles, and
   the burner has a convergence point of the blown flows of the silica powder, oxygen gas, and hydrogen gas located in front of the burner.
[18] The method for spray coating silica powder according to any one of [15] to [17], wherein the supply amount of silica powder is set to a set value selected from the range of 0.1 to 6 g/min per quartz burner, and the amount of variation from the set value is ±3% or less with respect to the set value.
[19] The method for spray coating silica powder according to any one of [15] to [18], wherein the amount of metal impurities in the silica powder is 0.1 ppm or less.
[20] The method for spray coating silica powder according to any one of [15] to [19], wherein the silica powder stored in a hopper is supplied to the burner through a suction line made of a tube, and the surface of the silica powder stored in the hopper is smoothed with a smoothing member.
[21] The method for spray coating silica powder according to any one of [15] to [20], wherein the target member is a quartz jig used in a semiconductor manufacturing apparatus.

The present invention also includes the following aspects.
[1A] A method for spray coating silica powder, in which silica powder is pushed out by a carrier gas through a quartz burner having a three or more multi-layer structure, the silica powder is melted in an oxyhydrogen flame atmosphere, and sprayed onto a surface of a target material to form a coating.
[2A] The method for spray coating silica powder according to [1A], in which the burner has a body including a silica powder supply tube, an oxygen gas supply tube, and a hydrogen gas supply tube arranged in this order from the center in the radial direction thereof, and the burner has a tapered section that tapers from the body to a tip of the burner,
   the burner has oxygen gas nozzles arranged in multiple concentric circles in the tapered section,
   the burner is structured so that part of the hydrogen gas is introduced into the gaps between the oxygen gas nozzles, and
   the burner has a convergence point for the blown flows of silica powder, oxygen gas, and hydrogen gas in front of the burner.
[3A] The method for spray coating silica powder according to [1A] or [2A], in which the supply amount of silica powder is set to a set value selected from the range of 0.1 to 6 g/min per quartz burner, and the amount of variation from the set value is within ±3% with respect to the set value.
[4A] The method for spray coating silica powder according to any one of [1A] to [3A], in which the amount of metal impurities in the silica powder is 0.1 ppm or less.
[5A] The method for spray coating silica powder according to any one of [1A] to [4A], in which the silica powder stored in a hopper is supplied to the burner through a suction line made of a quartz tube, and the surface of the silica powder stored in the hopper is smoothed with a quartz smoothing member.
[6A] The method for spray coating silica powder according to any one of [1A] to [5A], in which the target member is a quartz jig used in a semiconductor manufacturing apparatus.

### Advantageous Effects of the Invention

The present invention increases the freedom of choice of the shape of the member to be coated, and the coating process can be performed from an arbitary angle. In addition, according to one embodiment of the present invention, a quartz member having a dense coating film without bubbles can be manufactured. According to one embodiment of the present invention, a coating film that is high in purity, smooth, and without bubbles can be formed.

### Brief Description of the Drawings

[Fig. 1] Fig. 1a is a front view of a burner according to an embodiment, and Fig. 1b is a cross-sectional view along the line B-B.
[Fig. 2] A perspective view showing a hopper in a seethrough state.

### Description of Embodiment

The following describes in detail the embodiment of the present invention, but the present invention is not limited to the following embodiment, and can be carried out in various modifications within the scope of its gist.

The method for manufacturing a quartz member of the present invention includes a step of spraying a carrier gas containing silica powder onto a surface of a target member through a burner, wherein the step is performed in an oxyhydrogen flame atmosphere, and the temperature of the target member surface is 1401°C or higher and 2000°C or lower.

### [Step of spraying silica powder onto a target member surface]

The method for manufacturing a quartz member of the present invention includes a step of thermally spraying silica powder onto a target member surface.

The temperature at which the silica powder is sprayed onto the target member surface is preferably 1401°C or higher, more preferably 1500°C or higher, even more preferably 1600°C or higher, even more preferably 1700°C or higher, and most preferably 1750°C or higher, from the viewpoint of melting and sintering the silica powder on the target member surface. Also, from the viewpoint of sintering the silica powder without vaporizing it, it is preferably 2000°C or lower, more preferably 1950°C or lower, even more preferably 1900°C or lower, and even more preferably 1850°C or lower.

### [Quartz burner]

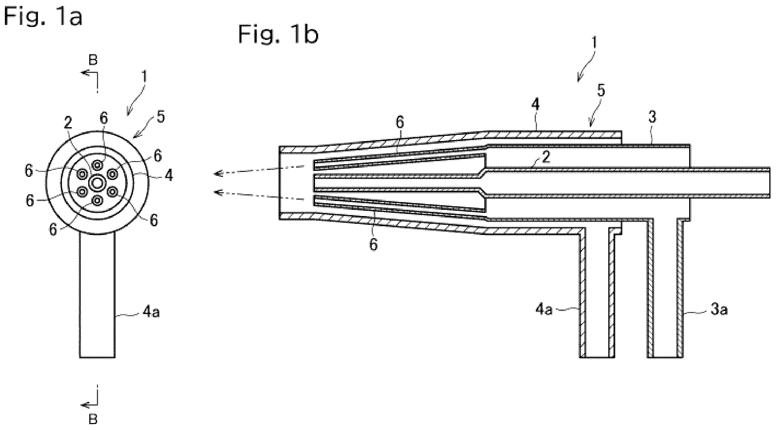

FIG. 1 shows a burner 1, which is an example of a burner according to an embodiment of the present invention, wherein FIG. 1a is a front view and FIG. 1b is a cross-sectional view along the line B-B in FIG. 1a.

The burner used in the present invention has a supply pipe for silica powder, which is the raw material.

The method for supplying silica powder is not particularly limited, but it is preferable to use a silica powder feed device, which will be described later.

The burner used in the present invention has a supply tube for the gas to be burned.

The gas to be burned is not particularly limited, but from the viewpoints of flammability and safety, hydrogen and oxygen are preferable.

The burner used in the present invention preferably has a cross-section with a multi-layer structure from the viewpoints of stable supply of raw materials and gases and safety.

The number of structures in the multi-layer structure is not particularly limited, but when oxygen gas, hydrogen gas, and silica powder are supplied, it is preferable to have three or more structures, as in the burner 1 shown in FIG. 1.

Furthermore, from the viewpoint of a stable supply of silica powder, it is preferable that the burner has a supply tube configuration in which the silica powder supply tube, the oxygen gas supply tube, and the hydrogen gas supply tube are arranged in this order in the radial direction from the center of the cross section of the burner. Furthermore, it is preferable that the burner has a structure in which part of the hydrogen gas is introduced into the gaps between the oxygen gas nozzles.

Furthermore, from the viewpoint of forming a dense coating film, it is preferable that the burner has a tapered portion from a body to a tip thereof, and that the tapered portion has oxygen gas nozzles arranged on a concentric circle. However, it may be configured so that a single circular nozzle covers the nozzles on the center side.

Furthermore, from the viewpoint of introducing hydrogen gas into the gaps of the gas nozzles, the number of oxygen gas nozzles arranged on a concentric circle is preferably four or more, more preferably five or more, and even more preferably six or more.

As shown in FIG. 1, the burner 1, which is an example of a burner used in the present invention, has a body 5. The body 5 has a three or more multiple tube structure in which a supply tube 2 of the silica powder as the raw material, an oxygen gas supply tube 3, and a hydrogen gas supply tube 4 are arranged in this order in the radial direction from the center of the body. The rear ends of the oxygen gas supply tube 3 and the hydrogen gas supply tube 4 are closed with a closing member (not shown) respectively. The oxygen gas supply tube 3 and the hydrogen gas supply tube 4 are provided with gas introduction portions 3a and 4a.

The burner 1 has a tapered section T that becomes narrower toward the tip from the body 5 to the tip thereof.

The burner has oxygen gas nozzles 6 arranged at equal circumferential positions on a concentric circle in the tapered section T. Part of the hydrogen gas is introduced into the gaps between the oxygen gas nozzles 6. The tip side of the oxygen gas supply tube 3 is communicated only with the oxygen gas nozzles 6. Six oxygen gas nozzles 6 are shown, but this is not limited to this.

The burner used in the present invention preferably has a convergence point for the blowing flows of raw silica powder, oxygen gas, and hydrogen gas in front of the burner, from the viewpoint of forming a dense coating film.

The burner 1, which is an example of a burner used in the present invention, has a convergence point in front of it for the blowing flows of raw silica powder, oxygen gas, and hydrogen gas. The axial direction of each oxygen gas nozzle 6 is directed toward the convergence point.

The silica powder as the raw material blown out from the central silica powder supply pipe 2 together with the carrier gas is guided by the surrounding combustion flames of the oxygen and hydrogen gas and efficiently gathers near the convergence point. The silica powder melts by receiving the heat required for melting, and is sprayed onto a surface of a target material to form a quartz coating.

The material of the burner used in the manufacturing method of the present invention is not particularly limited, but it is preferable that the burner is made of quartz from the viewpoint of heat resistance.

### [Silica powder as a raw material]

It is preferable that the silica powder as the raw material has high purity (e.g., over 5N), since this increases the purity of a film to be formed. However, depending on the application, silica powder with a purity of 5N or less, such as natural quartz powder, may be used.

### <Particle size of silica powder>

The particle size of silica powder as the raw material is usually 20-400 µm, preferably 40-200 µm, and more preferably 50-80 µm.

When the particle size of the silica powder as the raw material is 20 µm or more, the silica powder is less likely to vaporize when it is thermally sprayed from the nozzle and is less likely to become fumed silica, whereby increasing the film formation yield. When the particle size is 400 µm or less, the silica powder is more likely to be guided by the oxyhydrogen combustion flame, and a film is formed on the target surface without variation or scatter.

### [Target member]

The target member on which the coating is to be formed is preferably a quartz jig, examples of which include an etching ring in a plasma etching apparatus, a quartz plate, a rectangular cleaning tank, and a furnace tube used in an apparatus for forming an oxide coating on a semiconductor wafer.

It is preferable that the target material has a linear expansion coefficient close to that of silica in order to prevent stress from occurring due to differences in linear expansion after film formation. Specifically, it is preferable that the average linear expansion coefficient of the coating surface is 0.5 to 0.6 x 10⁻⁶ [K⁻¹]. When a primary layer having an average linear expansion coefficient close to the above average linear expansion coefficient is formed on the surface of the target material on which a coating is to be coated, the material of the target material itself may be other than quartz.

### [Silica powder feeding device]

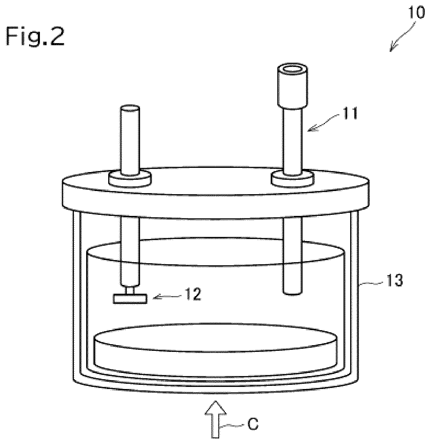

As shown in FIG. 2, a silica powder feeding device 10 has a hopper 13 for storing silica powder as the raw material, and a suction line 11 made of a quartz tube for sucking up the silica powder in the hopper 13. The silica powder as the raw material is sucked up into the suction line 11 together with the carrier gas by the negative pressure generated by the ejection of oxygen gas and hydrogen gas from the burner 1. A quartz scraper 12 is provided as a member for smoothing the top surface of the silica powder stored in the hopper 13.

In this case, it is preferable that the tube and scraper are made of quartz.

The carrier gas is introduced into the hopper 13 from near the center of the bottom of the hopper 13, as shown by an arrow C. Nitrogen gas, oxygen gas, air, or the like is used as the carrier gas.

### [Step of spraying silica powder onto a surface of a target member]

The manufacturing method of the quartz member of the present invention includes a step of thermally spraying silica powder onto a surface of a target member. When performing coating the target member, the tip of the burner 1 is positioned toward the target member, and the distance from the tip of the burner 1 to the target member is adjusted.

The surface temperature of the target member when spraying the silica powder onto the surface of the target member is preferably 1401°C or higher, more preferably 1500°C or higher, even more preferably 1600°C or higher, even more preferably 1700°C or higher, and most preferably 1750°C or higher, from the viewpoint of melting and sintering the silica powder on the surface of the target member. From the viewpoint of sintering the silica powder without vaporizing it, the temperature is preferably 2000°C or less, more preferably 1950°C or less, even more preferably 1900°C or less, and even more preferably 1850°C or less. The above temperature is measured by measuring the surface temperature of the target material while the burner is flaming without supplying the silica powder as the raw material.

Thereafter, while maintaining the burner 1 in a flaming state, silica powder as the raw material is supplied. Then, a step of coating the surface of the target material is performed by moving the burner or by moving the target material while keeping the distance from the tip of the burner to the target material constant. The coating does not need to be formed on the entire surface of the target material, and only a part of the target material may be coated with the coating.

Silica powder as the raw material does not need to be always supplied. After a predetermined coating thickness is obtained, a flattening process of the coating surface may be performed by heating the coating surface with only the oxyhydrogen flame.

### [Examples]

### [Example 1]

A flat quartz plate with a diameter of 150 mm and a thickness of 30 mm was used as the target material. The quartz plate was fixed on a horizontal turntable.

The burner 1 in Fig. 1 was fixed facing downwards with the tip of the burner 150 mm away from the target material. The spraying location on the target material was located 60 mm away from the center of rotation of the turntable.

Silica powder with an average particle size of 200 µm (metallic impurity amount 0.1 ppm or less, 4N) was supplied at 6 g/min with a carrier gas flow rate of 2 L/min, and the silica powder was melted and coated with an oxyhydrogen flame under conditions of a hydrogen gas flow rate of 80 L/min and an oxygen gas flow rate of 30 L/min so that the temperature of the target material surface was 1700°C. Nitrogen gas was used as the carrier gas.

The target material was sprayed while rotating at 1 rpm to form a ring-shaped build-up coating. Then the center of rotation of the target material was shifted by 8 mm and another ring-shaped build-up coating was formed in the same way so that the ring-shaped build-up coatings overlapped partially. After that, the powder supply was stopped, and additional heating was performed for one turn of the target with an oxyhydrogen flame. This resulted in the formation of a transparent and smooth coating surface.

### [Example 2]

As a target member, a quartz member having a columnar shape with a diameter of 100 mm and a length of 300 mm was placed on a horizontal turntable with the axis of the columnar member in the vertical direction. This turntable was also movable in the up and down directions.

The burner 1 shown in Fig. 1 was placed facing the circumferential surface of the target member. The burner 1 was installed such that the spray direction thereof faces downward at an angle of 30° relative to the horizontal. The tip of the burner was placed 150 mm away from the circumferential surface of the target member. The target member was rotated around its axis at 1 rpm.

Silica powder as the raw material with an average particle size of 80 µm (metal impurity amount 0.1 ppm or less, 4N) was supplied at a supply rate of 0.6 g/min using a carrier gas of 1.6 L/min to coat the circumferential surface of the target member so that the temperature of the surface of the target member was 1700°C. Furthermore, the position of the quartz burner was changed in the height direction by 8 mm every time the target member turned once, and the coating was continued to be formed in the same way, thereby forming a coating on the circumferential surface of the target member. In this case, a flat coating surface was formed even without additional heat from an oxyhydrogen flame.

Although the present invention has been described in detail using specific embodiments, it will be apparent to those skilled in the art that various modifications are possible without departing from the spirit and scope of the present invention.

This application is based on Japanese Patent Application No. 2022-038271 filed on March 11, 2022, and is incorporated by reference in its entirety.

### Reference Signs List

- 1: Burner
- 2: Silica powder supply tube
- 3: Oxygen gas supply tube
- 4: Hydrogen gas supply tube
- 5: Body
- 6: Oxygen gas nozzle
- 10: Silica powder feed device
- 11: Suction line
- 12: Scraper
- 13: Hopper

## Claims

1. A method for manufacturing a quartz member, comprising a step of spraying a carrier gas containing silica powder onto a surface of a target member through a burner,
wherein the step is performed in an oxyhydrogen flame atmosphere, and the temperature of the target member surface is 1401°C or higher and 2000°C or lower.

2. The method for manufacturing a quartz member according to claim 1, wherein the burner has a multi-layer structure.

3. The method for manufacturing a quartz member according to claim 2, wherein the multi-layer structure is a triple or more multi-layer structure.

4. The method for manufacturing a quartz member according to claim 1, wherein the burner has supply tubes for silica powder, oxygen gas, and hydrogen gas.

5. The method for manufacturing a quartz member according to claim 4, wherein the supply tubes of the burner are arranged such that the supply tube for silica powder, the supply tube for oxygen gas, and the supply tube for hydrogen gas are positioned in this order in the radial direction from the center of the burner.

6. The method for manufacturing a quartz member according to claim 4, wherein the burner has a convergence point for the blowing flows of silica powder, oxygen gas, and hydrogen gas in front of the burner.

7. The method for manufacturing a quartz member according to claim 1, wherein the burner has a tapered section tapered from the body to the tip of the burner, and the burner is provided with oxygen gas nozzles arranged in the tapered section on a concentric circle.

8. The method for manufacturing a quartz member according to claim 7, wherein a plurality of oxygen gas nozzles are arranged on a concentric circle in the tapered section.

9. The method for manufacturing a quartz member according to claim 8, wherein the burner is structured so that part of hydrogen gas flows into gaps between the oxygen gas nozzles.

10. The method for manufacturing a quartz member according to claim 1, wherein the burner is a quartz burner.

11. The method for manufacturing a quartz member according to claim 1, wherein the supply amount of silica powder is set to a set value selected from the range of 0.1 to 6 g/min per burner, and the amount of variation from the set value is ±3% or less with respect to the set value.

12. The method for manufacturing a quartz member according to claim 1, wherein an amount of metal impurities in the silica powder is 0.1 ppm or less.

13. The method for manufacturing a quartz member according to claim 1, further comprising a step of supplying the silica powder stored in a hopper to the burner through a suction line made of a tube, and a step of smoothing the surface of the silica powder in the hopper with a smoothing member.

14. The method for manufacturing a quartz member according to claim 1, wherein the quartz member is a quartz jig.

15. A method for spray coating a silica powder, comprising spraying a carrier gas containing silica powder onto a surface of a target member under an oxyhydrogen flame atmosphere through a burner having a multi-layer structure, wherein the burner is a quartz burner with a multi-layer structure of three or more layers; and, the silica powder is sprayed with the carrier gas while being melted under the oxyhydrogen flame atmosphere onto the surface of the target member to form a coating.

16. The method for spray coating a silica powder according to claim 15, wherein the multi-layer structure is a multi-layer structure of three or more layers.

17. The method for spray coating a silica powder according to claim 15 or 16,
wherein the burner has a body including therein a silica powder supply tube, an oxygen gas supply tube, and a hydrogen gas supply tube in the radial direction from the center,
the burner has a tapered section from the body to the tip of the burner,
the tapered section is provided with a plurality of oxygen gas nozzles arranged in multiple concentric circles,
the burner has a structure in which part of the hydrogen gas flows into gaps between the oxygen gas nozzles, and
the burner has a convergence point of the blown flows of the silica powder, oxygen gas, and hydrogen gas located in front of the burner.

18. The method for spray coating silica powder according to any one of claims 15 to 17, wherein the supply amount of silica powder is set to a set value selected from the range of 0.1 to 6 g/min per quartz burner, and the amount of variation from the set value is ±3% or less with respect to the set value.

19. The method for spray coating silica powder according to any one of claims 15 to 18, wherein the amount of metal impurities in the silica powder is 0.1 ppm or less.

20. The method for spray coating silica powder according to any one of claims 15 to 19, wherein the silica powder stored in a hopper is supplied to the burner through a suction line made of a tube, and the surface of the silica powder stored in the hopper is smoothed with a smoothing member.

21. The method for spray coating silica powder according to any one of claims 15 to 20, wherein the target member is a quartz jig used in a semiconductor manufacturing apparatus.
